# EUROPEAN PATENT SPECIFICATION

(11) **EP 0 878 739 B1**
(45) Date of publication and mention of the grant of the patent: **27.11.2002**
(21) Application number: 98108552.5
(22) Date of filing: 11.05.1998
(51) Int. Cl.: G03F 7/012

(54) **Photosensitive compounds, photosensitive resin compositions, and pattern formation method making use of the compounds or compositions**
Photoempfindliche Verbindungen, photoempfindliche Harzzusammensetzungen, und Verfahren zur Herstellung von Mustern unter Verwendung dieser Verbindungen oder dieser Zusammensetzungen
Composés photosensibles, compositons à base de résines photosensibles, et procédé de formation d'images utilisant ces composés ou ces compositions

(30) Priority: 13.05.1997 JP 12186097; 02.09.1997 JP 23749097
(43) Date of publication of application: 18.11.1998
(73) Proprietor: Toyo Gosei Kogyo Co., Ltd., Ichikawa-shi, Chiba 272-0012 (JP)
(72) Inventor: Shibuya, Toru, c/o Toyo Gosei Kogyo Co., Ltd., Inba-mura, Inba-gun, Chiba 270-1601 (JP); Xie, Jian Rong, c/o Toyo Gosei Kogyo Co., Ltd., Inba-mura, Inba-gun, Chiba 270-1601 (JP); Tochizawa, Noriaki, c/o Toyo Gosei Kogyo Co., Ltd., Inba-mura, Inba-gun, Chiba 270-1601 (JP)
(74) Representative: Strehl Schübel-Hopf & Partner

(56) References cited:
- US-A- 4 241 162
- DATABASE WPI Section Ch, Week 9038 Derwent Publications Ltd., London, GB; Class A89, AN 90-287901 XP002076101 & JP 02 204 750 A (HITACHI LTD)
- DATABASE WPI Section Ch, Week 8743 Derwent Publications Ltd., London, GB; Class A89, AN 87-304344 XP002076102 & JP 62 215 606 A (AGENCY OF IND SCI & TECHNOLOGY)

## Description

### BACKGROUND OF THE INVENTION

### Field of the Invention

The present invention relates to novel photosensitive compounds and photosensitive resin compositions, as well as to a pattern formation method making use of such photosensitive compounds or resin compositions. The photosensitive compounds and photosensitive resin compositions according to the invention are endowed with high sensitivity and excellent storage stability, provide improved resolution, and thus have a wide range of utility including, for example, color cathode-ray tubes and other display tubes, screen printing, immobilized enzymes, PS (presensitized) plates, and etching resists.

### Description of the Related Art

Conventionally, negative-type photoresists used for the formation of black matrix and phosphor patterns of color cathode-ray tubes have made use of resists composed of a water-soluble polymer (such as polyvinyl alcohol) and a bichromate salt (hereafter, resists of this type will be referred to as PVA-ADC-based resists). Photoresists of this type have a fundamental disadvantage in that they require a special treatment facility for preventing environmental pollution, which is otherwise caused due to the presence of bichromate salts.

As photoresists that are free from the above problem, there have been known photosensitive compositions containing a water-soluble diazide compound (e.g., sodium 4,4'-diazidostilbene-2,2'-disulfonate (hereinafter abbreviated DAS)) which serves as a photocrosslinking agent and a water-soluble polymer that is photocrosslinkable in the presence of the water-soluble diazide compound. Among such known photosensitive compositions are those containing, as photocrosslinkable water-soluble polymers, vinyl alcohol-maleic acid copolymers or salts thereof (Japanese Patent Application Laid-Open (*kokai*) No. 48-97602), vinyl alcohol-acrylamide copolymers (Japanese Patent Application Laid-Open (*kokai*) No. 48-97603), or water-soluble polyvinyl butyral (Japanese Patent Application Laid-Open (*kokai*) No. 48-98905). In practice, however, these compositions cannot be used because of their low sensitivity. In the meantime, known compositions having sufficient sensitivity in practice include those containing polyvinylpyrrolidone (hereinafter abbreviated PVP) and a water-soluble bisazide compound serving as an additive (hereafter, compositions of this type will be referred to as PVP-DAS-based resists; see, for example, Japanese Patent Application Laid-Open (*kokai*) No. 48-90185) and those containing an acrylamide-diacetoneacrylamide copolymer (hereinafter abbreviated PAD) and water-soluble bisazide serving as an additive (hereafter, compositions of this type will be referred to as PAD-DAS-based resists; see, for example, Japanese Patent Application Laid-Open (*kokai*) No. 50-33764).

PVA-ADC-based resists, when used for the formation of black matrix of color cathode-ray tubes, present a drawback of poor resolution, in addition to the aforementioned problem of environmental pollution, due to low oxygen permeability and lack of reciprocity-law failure characteristics. In contrast, when PVP-DAS-based resists are used, due to their excessively high oxygen permeability, proper sensitivity cannot be obtained unless the thickness of coating film is increased, which in turn reduces resolution. PAD-DAS-based resists, on the other hand, are endowed with excellent sensitivity and resolution, but after they have undergone formation of resist patterns and coating of graphite, they provide poor etching characteristics, and, depending on the type of graphite, etching cannot be effected.

With regard to use for the formation of phosphor patterns, PVA-ADC-based resists are unsatisfactory in terms of both environmental pollution and sensitivity, and in addition, chromium oxide which remains after firing degrades luminance of the phosphor. In this connection, PVP-DAS-based resists and PAD-DAS-based resists have drawbacks in terms of sensitivity, and therefore cannot be used.

Meanwhile, Japanese Patent Application Laid-Open (*kokai*) Nos. 55-23163, 55-62905 and 56-11906 disclose non-chromium resists which are used for the formation of phosphor patterns and which contain as a photosensitive unit a photosensitive resin obtained through a condensation reaction between polyvinyl alcohol and a quaternary ammonium salt (e.g., a styrylpyridinium salt or a styrylquinolinium salt) (hereafter, resists of this type are referred to as PVA-SbQ-based resists).

However, these PVA-SbQ-based resists are not necessarily satisfactory in terms of resolution, although they have advantages such as shorter time required for photosensitization. Moreover, since their ionicity is limited to cationic, use and compositions of the resists are also limited. Furthermore, since a mercury lamp (365 nm) and a metal halide light source (400 nm) are used as light sources for exposure, 4-methylquinoline or a similar substance must be used so as to set the photosensitive wavelength of the resists in a longer wavelength range. This is disadvantageous because of the accompanying increase in cost.

Methods for the formation of color filters for use with color cathode-ray tubes are disclosed in, among others, Japanese Patent Application Laid-Open (*kokai*) Nos. 5-266795, 8-87962, and 8-185799. All of these methods employ dichromate salts as crosslinking agents, and therefore are not completely satisfactory in view of disadvantages such as environmental pollution, low sensitivity, intricate processing, etc.

As described above, there exist no conventional photoresists that satisfy requirements in terms of environmental pollution, sensitivity, and resolution, simultaneously. Therefore, in certain uses, such as color cathode-ray tubes, other display tubes, and screen printing, there is still need for resists that exhibit excellent sensitivity at a wavelength as long as 400 nm and that are dissolvable or dispersible in an aqueous solvent. Particularly, in consideration of the excellent characteristics of polyvinyl alcohol (hereinafter abbreviated PVA) in use for the formation of phosphor patterns, demand exists for PVA-based resists of a certain type which have a longer photosensitive wavelength than the wavelength possessed by PVA-SbQ-based resists, and in addition, which, with regard to ionicity, permit selection between anionic and nonionic in accordance with the use.

Also, there exists need for a pattern formation method making use of a composition which is endowed with high sensitivity, has improved adhesion characteristics against a substrate, and exhibits excellent coating characteristics and stability during storage. Particularly, there exists strong need for a pattern formation method in which an advantage related to reciprocity-law failure characteristics―which can be obtained when a water-soluble polymer and a water-soluble azide compounds are used in combination―is maintained and which makes use of a photosensitive composition which is endowed with high sensitivity, has improved adhesion characteristics with a substrate, and exhibits excellent coating characteristics and stability during storage.

### SUMMARY OF THE INVENTION

In view of the foregoing, an object of the present invention is to provide a photosensitive compound capable of providing novel photosensitive resins, and photosensitive resins prepared from such a compound.

Another object of the present invention is to provide a pattern formation method making use of a photosensitive resin composition which does not invite pollution, which is endowed with high resolution and improved sensitivity, and which has excellent adhesion to substrates, coating characteristics, and storage stability.

The photosensitive compound of the present invention, which overcomes the above-described problems, comprises a unit represented by the following formula (I) : 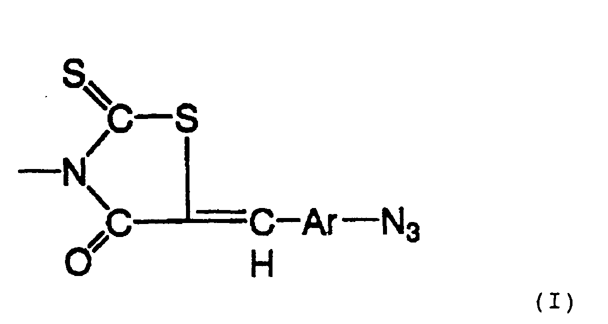 wherein Ar is selected from the following formula group (II): 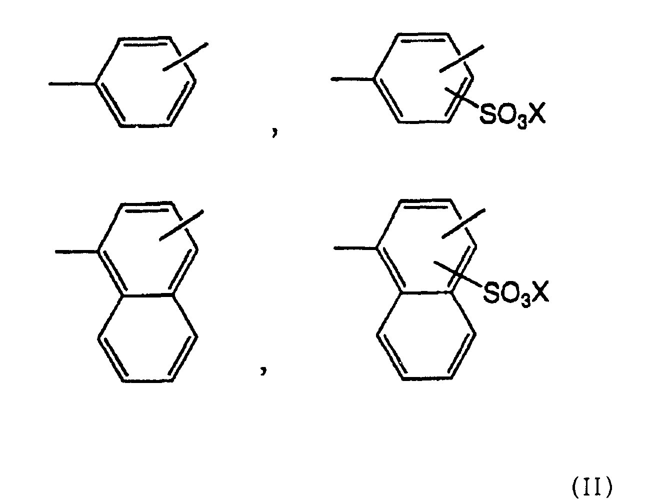 and X represents lithium, sodium, potassium, ammonium, monoalkylammonium, dialkylammonium, trialkylammonium, or tetraalkylammonium.

In particular, the photosensitive compound of the present invention is represented by the following formula (III): 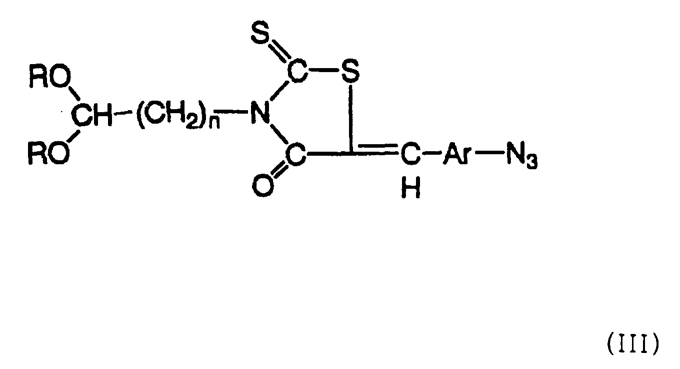 wherein R is selected from among C1-C6 alkyl groups and groups formed of two R's joined to each other, i.e., -(CH₂)ₘ-, (m is 2 or 3); n is 1, 2, or 3; and Ar has the same meaning as described above.

The photosensitive resin of the present invention comprises a unit represented by the above-described formula (I). Ar has the same meaning as described above.

In particular, the photosensitive resin of the present invention has a structural unit represented by the following formula (IV): 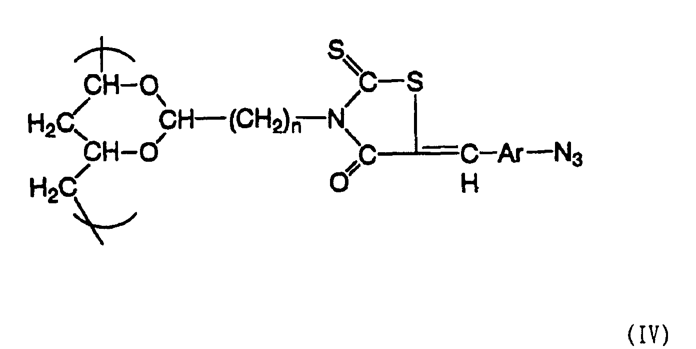 wherein n is 1, 2, or 3 and Ar has the same meaning as described above.

The photosensitive resin composition of the present invention contains the aforementioned photosensitive resin of the present invention.

Further, the method for the manufacture of photosensitive compound of the present invention is directed to the production of a azide-group-containing photosensitive compound and comprises the following reaction step (V): 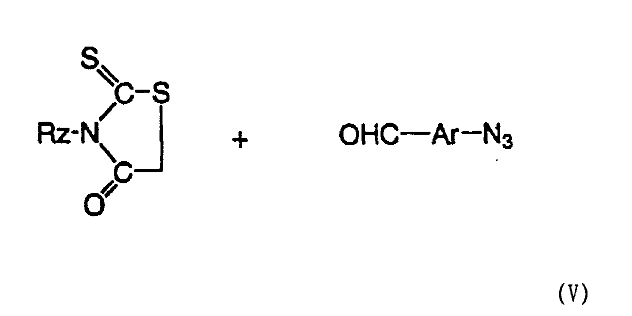 wherein Rz represents hydrogen or a substituent and Ar has the same meaning as described above.

The above-described Rz is a substituent containing, for example, an acetal group.

The method for the manufacture of the photosensitive resin of the present invention is directed to the production of a azide-group-containing photosensitive resin and comprises a reaction step represented by the above-described formula (V).

Rz and Ar have the same meanings as described above.

In the case in which the above-described Rz is a substituent containing, for example, an acetal group, the method for the manufacture of the photosensitive resin of the present invention may further comprise a step including reaction of the acetal group to form a saponified product of polyvinyl acetate.

The present inventors have conducted earnest studies to overcome the above-described drawbacks, and have found that condensation of a rhodanine compound having a variety of substituents (such as an acetal group) and a water-soluble aldehyde having a azide group or an aldehyde having an aromatic ring containing a azide group provides an azide compound having a new rhodanine skeleton. The present invention has been accomplished based on this finding.

In accordance with the present invention, a novel compound which has a new rhodanine skeleton and can be photosensitized at a long wavelength is provided through condensation of a rhodanine compound having an acetal group and an aromatic aldehyde having a azide group.

A photosensitive resin having a rhodanine skeleton is disclosed in U.S. Patent No. 2,824,087. However, the photosensitive resin of the present invention is different from the above-disclosed photosensitive compound in terms of the photosensitization mechanism. That is, the photosensitive resin of the present invention is cured through formation of nitrene through decomposition of a light-absorbed azide group and cross-linking reaction induced by coupling of the formed nitrenes, abstraction of hydrogen, etc. In this point, the photosensitive resin of the present invention is completely different from those described in the above-described U.S. patent.

### BRIEF DESCRIPTION OF THE DRAWING

FIG. 1 is a graph showing the results of a test conducted on compounds prepared in Examples.

### DETAILED DESCRIPTION OF THE INVENTION

The photosensitive compound or photosensitive resin in accordance with the present invention has a unit represented by the above-described formula (I). It exhibits photosensitivity of the azide type, is photosensitizable at a long wavelength, and has excellent stability. A variety of photosensitive compounds or resins can be designed relatively easily through introduction of the unit.

The compound of the present invention having a unit of the above-described formula (I) may be obtained through condensation of a variety of rhodanine compounds, and a azide-group-containing derivative of benzaldehyde or arylaldehyde or an aldehyde compound having an aromatic ring containing a azide group.

A rhodanine compound which may be used in the present invention is represented by the following formula (1): 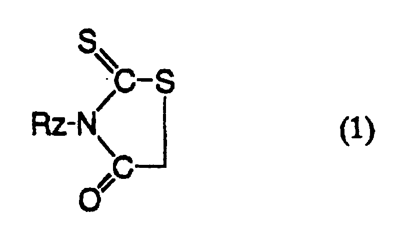 wherein the above-described Rz represents hydrogen or a substituent, e.g., a reactive group for bonding to a variety of resins. When Rz is hydrogen, a variety of substituents may be introduced after condensation reaction with, for example, benzaldehyde having the above-described azide group.

Typical examples of the rhodanine compound include a compound in which Rz is a substituent having an acetal group, and such a rhodanine compound is represented by the following formula (2):

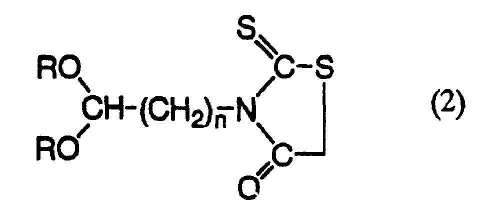

The rhodanine compound may be obtained through, for example, reaction of an acetal compound having an amino group with carbon disulfide in the presence of a base such as ammonia, triethylamine, NaOH, or KOH to thereby obtain dithiocarbamate, and further reaction of dithiocarbamate with ethyl chloroacetate. No particular limitation is imposed on the reaction solvent, and water, an ether, or DMF may be selected for use depending on an amine compound to be used.

An aromatic aldehyde compound having a azide group, or an aldehyde compound having an aromatic ring containing a azide group, which can be condensed with the rhodanine compound, is represented by the following formula (3):

**OHC―Ar―N**_{**3**} **(3)**

wherein Ar has the same meaning as described before.

These compounds impart, according to needs, water-solubility to the photosensitive compound of the present invention, and for such a purpose, water-soluble compounds are used.

The photosensitive compound represented by formula (III) is obtained through use of the rhodanine compound represented by the above-described formula (2). Further, the photosensitive compound may be transformed into the photosensitive resin of the present invention of the above-described formula (IV) through reaction in the presence of an acid catalyst with a saponified product of polyvinyl acetate, or with a water-soluble copolymer of vinyl alcohol and another vinyl compound.

Preferably, the saponified product of polyvinyl acetate has an average polymerization degree of 200-5,000 and a saponification degree of 60-100%, for example. Examples of the saponified product of polyvinyl acetate which may be used include a saponified product of polyvinyl acetate modified with a hydrophilic group, an anion, a cation, or a reactive group such as an acetoacetyl group.

When the average polymerization degree is less than 200, obtaining the sufficient sensitivity is difficult, whereas when it is in excess of 5,000, the viscosity of a solution of the photosensitive resin increases, often disadvantageously resulting in poor coating characteristics. Furthermore, when the concentration is decreased in order to reduce the viscosity, obtaining the desired coating film thickness is difficult. When the saponification degree is less than 60%, obtaining sufficient water-solubility and water-developability is difficult.

The water-soluble copolymer of vinyl alcohol and another vinyl compound which may be used has an average polymerization degree of 200-5,000, for example. Examples of the vinyl monomers to be copolymerized with vinyl alcohol include N-vinylpyrrolidone and acrylamide.

When such saponified products of polyvinyl acetate are reacted with the photosensitive compound represented by the above-described formula (III) in the presence of an acid catalyst to thereby obtain the photosensitive resin represented by the above-described formula (IV), an aldehyde or a ketone may simultaneously be reacted. Examples of aldehydes include aliphatic aldehydes such as formaldehyde, acetoaldehyde, propionaldehyde, butylaldehyde, and crotonaldehyde; aromatic aldehydes or their acetals such as benzaldehyde sulfonate, benzaldehyde di-sulfonate, sodium 4-azido-2-sulfobenzaldehyde, carboxybenzaldehyde, hydroxybenzaldehyde, and a formylstyrylpyridinium salt. Examples of ketones include acetone and methyl ethyl ketone.

The ratio of introduction of the photosensitive compound represented by formula (III) to a saponified product of polyvinyl acetate is preferably about 0.3-5 mol% per unit.

The pattern formation method of the present invention comprises a coating film formation step in which a photosensitive resin composition containing a photosensitive resin having a structural unit represented by the above-described formula (IV) is applied onto a substrate; an exposure step in which the coating film of the photosensitive composition is irradiated for a desired pattern; and a development step in which the patternwise exposed coating film is developed with water or an aqueous developer to form a photo-cured pattern.

The above-described photosensitive resin composition may further contain a water-soluble polymer or a water-soluble azide compound. The above-described substrate may be an inner face plate of a color cathode-ray tube.

The pattern formation method may further comprise, after the above-described development step, steps of applying a graphite slurry onto the entirety of the above-described photo-cured pattern, drying to form a graphite coating film, and removing the above-described photo-cured pattern by use of a remover to form a black matrix.

Alternatively, the above-described photosensitive resin composition may further contain a phosphor, and a phosphor pattern may be formed through the above-described development step.

Also, the above-described photosensitive resin composition may further contain a pigment, and a color filter may be formed through the above-described development step.

The pattern formation method of the present invention is performed by use of a photosensitive resin composition containing a photosensitive resin represented by the above-described formula (IV).

As described above, the photosensitive resin may be used together with a water-soluble polymer. Examples of the polymer include a saponified product of polyvinyl acetate; a polymer of natural product such as gelatin, a cellulose derivative, or casein; and a polymer or a copolymer comprising a water-soluble vinyl monomer. Examples of the water-soluble vinyl monomer include N-vinylformamide, N-vinylacetamide, vinylpyrrolidone, acrylamide, diacetoneacrylamide, N,N-dimethylacrylamide, vinylpyridine, methacrylamide, and allylthiourea. The content of the resin represented by formula (IV) in relation to the total amount of water-soluble polymer is preferably 0.5% or more.

As described above, the photosensitive resin may be used in combination with a water-soluble azide compound. Examples of the water-soluble azide compounds include 4,4'-diazidostilbene-2,2'-disulfonic acid, 4,4'-diazidobenzalacetophenone-2-sulfonic acid, 4,4'-diazidostilbene-α-carboxylic acid, and salts thereof such as alkali metal salts, ammonium salts, and organic amine salts. Further, there is preferably used water-soluble azide compounds described in Japanese Patent Application Laid-Open (*kokai*) Nos. 49-102404, 50-141403, 2-204750, 4-26849, 5-11442, 5-113661, and 6-239930.

Additives such as ethylene glycol, sorbitol, and surfactants may optionally be added to the photosensitive resin composition used in the present invention in order to improve the coatability and moisture-retention property thereof. A silane coupling agent which serves as an adhesion-accelerator may optionally be added to the photosensitive resin composition used in the present invention in order to improve adhesion thereof to a substrate. Examples of the adhesion-accelerators which may be used include N-β(aminoethyl)-aminopropylmethyldimethoxysilane and N-β(aminoethyl)-γ-aminopropyltrimethoxysilane.

Additives such as a preservative, a defoaming agent, or a pH-adjusting agent may optionally be added to the photosensitive resin composition used in the present invention.

Hydrophobic polymer emulsions may optionally be added to the photosensitive resin composition used in the present invention in order to improve the film strength, water resistance, and adhesion to a variety of substrates. Examples of the hydrophobic emulsions include a polyvinyl acetate emulsion, a polyacrylic acid emulsion, and a urethane emulsion. A pattern formation method by use of a composition containing the hydrophobic polymer emulsion is suitably employed for a screen printing plate, for example.

Further, colorants such as a pigment or a dye may be added to the photosensitive resin composition used in the present invention in order to prevent halation induced by exposure and to obtain a colored image.

In particular, the colored image obtained through dispersing a pigment in the photosensitive resin composition used in the present invention may be applied to a color filter for a liquid crystal display, for a color cathode-ray tube, and for a plasma display; a color proof for printing; a secondary original image for printing; etc.

The pattern formation method by use of the photosensitive resin composition as described above comprises, for example, a coating film formation step in which a photosensitive resin composition is applied onto a substrate; an exposure step in which the photosensitive composition coating film is irradiated for a desired pattern; and a development step in which the patternwise exposed photosensitive composition coating film is developed with water or an aqueous developer to form a photo-cured pattern.

Examples of the above-described substrate include an inner face plate of a color cathode-ray tube. Consequently, a black matrix of a color cathode-ray tube, a phosphor pattern, a color filter, etc. may be specifically formed.

The pattern formation method of the present invention will next be described in detail.

### (1) Step for forming a coating film of the photosensitive composition on a substrate

No particular limitation is imposed on the substrate which may be used in the present invention, and any substrate to which the photosensitive composition of the present invention can adhere may be used as the substrate. Examples of the above-described substrate include glass such as glass, SiO₂-treated glass, or ITO-coated glass; plastic films and sheets such as polyester films, polyamide films, polyvinyl chloride films, and polypropylene films; metal substrates; metal-laminated plastic sheets and films; mesh; and silicon wafers.

Examples of a coating method for the photosensitive composition of the present invention include spin coating, roll-coater coating, curtain coating, and applicator coating, which have conventionally been employed. The coated film is subsequently dried through a customary method at a specific temperature, to thereby obtain a coating film.

### (2) Pattern exposure step

Any customary light source may be used for the exposure of the above-described coating film of the photosensitive composition so long as it emits light having a wavelength at which the photosensitive resin of formula (IV) used in the present invention can be sensitized. Examples include an ultra-high-pressure mercury lamp, a high-pressure mercury lamp, a xenon lamp, a metal halide lamp, and a chemical lamp. Also, there may be employed any customary exposure method such as the magnification- or reduction-projection exposure method, the contact exposure method, or the proximity exposure method.

### (3) Development step

The above-described patternwise irradiated coating film of the photosensitive composition may be developed by use of water, a mixture solvent of water-aqueous solvent, or an aqueous solution containing an acid, an alkali, a pH-adjusting agent, a surfactant, etc. Examples of the development methods include spray-development, dipping-development, paddle-development, etc., which are customary methods.

As described above, the pattern formation method of the present invention is particularly advantageously applied to an inner face plate of a color cathode-ray tube. Application of the above-described pattern formation method to the above-described inner face plate of a color cathode-ray tube assures high sensitivity and high resolution, and therefore high productivity is realized.

For example, in the case in which a black matrix of a color cathode-ray tube is formed, graphite is applied onto the above-described formed pattern and the coated pattern is etched with a remover. In this case, a fine black matrix is obtained due to good etchability of the pattern formed in accordance with the present invention.

Examples of the removers include an aqueous solution of acidic compounds such as periodic acid or hydrogen peroxide; acids such as sulfuric acid, sulfamic acid, nitric acid, or dodecylbenzenesulfonic acid; and mixtures thereof.

In the case of formation of a phosphor pattern, the photosensitive composition of the present invention containing a phosphor is homogeneously applied onto a substrate on which the phosphor pattern is formed, e.g., the above-described black matrix in the inner face plate of a color cathode-ray tube, and dried. The coated composition is exposed to a UV beam through a specifically patterned mask, and then developed with water to exclusively leave the exposed parts. When three different phosphors of red (R), green (G), and blue (B) are employed, the above-mentioned steps are performed three times to thereby complete the phosphor face.

In the case of formation of a color filter of a color cathode-ray tube, the photosensitive composition of the present invention containing, for example, a pigment, is homogeneously applied onto a substrate on which the color filter is formed, i.e., the black matrix-equipped inner face plate of a color cathode-ray tube, and dried. The coated composition is exposed to a UV beam through a specifically patterned mask, and then developed with water so that the exposed parts alone remain. When three different inorganic pigments of red (R), green (G), and blue (B) are used, the above-described steps are performed three times to thereby obtain a complete color filter.

The present invention will next be described in detail with reference to the examples.

### (Photosensitive Resin Manufacture Example 1)

### (1) [Preparation of aqueous dispersion of 3-(2',2'-dimethoxyethyl)rhodanine]

Aminoacetaldehyde dimethylacetal (53 g) and sodium hydroxide (20 g) were dispersed and dissolved in water (200 g), and the mixture was cooled to 10°C. Carbon disulfide (38 g) was added dropwise over 30 minutes with stirring, followed by reaction at 20°C for 24 hours. Subsequently, ethyl chloroacetate (81 g) was added dropwise over 15 minutes, and the resultant mixture was allowed to react at room temperature for 24 hours, to thereby obtain an aqueous dispersion of the target compound of the following formula.

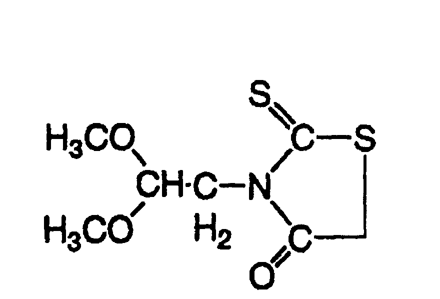

### (2) [Synthesis of 5-(sodium 4'-azido-2'-sulfobenzylidene)-3-(2", 2"-dimethoxyethyl)rhodanine]

Sodium 4-azido-2-sulfobenzaldehyde (120 g) and sodium hydroxide (30 g) were dissolved in water (2500 g). The mixture was cooled to 10°C and added slowly to the aqueous dispersion obtained in step (1). As the reaction proceeded, the target substance precipitated. Reaction was allowed to proceed for 24 hours with continued stirring. NaCl (150 g) was added to the reaction mixture, and stirring was continued for an additional 5 hours. The target substance was collected by filtration, and washed with acetone.

The product, which is represented by the following formula, had a purity of 95% as determined by liquid chromatography, and an absorption peak of 388 nm.

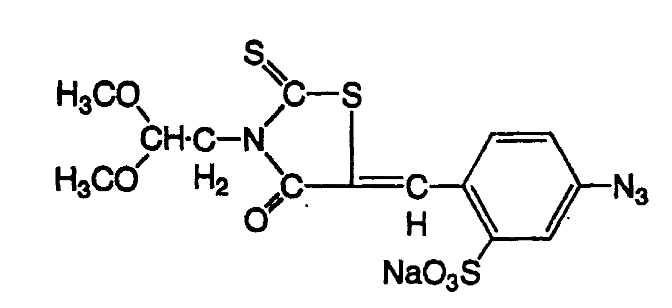

### (3) [Synthesis of Photosensitive Resin]

Polyvinyl alcohol (100 g)(GH-17, manufactured by Nippon Synthetic Chemical Industry Co., Ltd.) was dissolved in water (900 g). The compound (13 g) obtained in step (2) and phosphoric acid (3 g) were added to the mixture, followed by reaction at 80°C for 24 hours. The acetalization ratio was 90%. The reaction mixture was treated with an ion exchange resin to remove the phosphoric acid so as to prepare photosensitive liquid having photosensitive group introduced in an amount of 1.3 mol% with respect to PVA. Thereafter, ion-exchanged water was added to the photosensitive liquid, to thereby adjust the solid content to 6%.

### (Photosensitive Resin Manufacture Example 2)

### (1) [Preparation of aqueous dispersion of 3-(4',4'-dimethoxybuthyl)rhodanine]

Aminobutylaldehyde dimethylacetal (67 g) and an ammonia water (60 g) were dissolved in water (200 g), and the mixture was cooled to 10°C. Carbon disulfide (38 g) was added dropwise to the mixture over 30 minutes with stirring, followed by reaction at 20°C for 24 hours. Next, ethyl chloroacetate (81 g) was added dropwise over 15 minutes, and the resultant mixture was allowed to react at room temperature for 24 hours, to thereby obtain an aqueous dispersion of the target compound of the following formula.

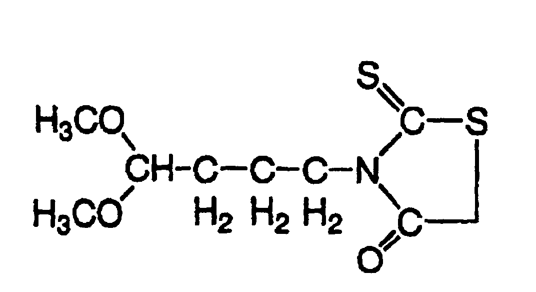

### (2) [Synthesis of 5-(sodium 4'-azido-2'-sulfobenzylidene)-3-(4",4"-dimethoxyethyl)rhodanine]

Sodium 4-azido-2-sulfobenzaldehyde (120 g) and sodium hydroxide (30 g) were dissolved in water (2500 g). The mixture was cooled to 10°C and added slowly to the aqueous dispersion obtained in step (1). As the reaction proceeded, the target substance precipitated. Reaction was allowed to proceed for 24 hours with continued stirring. NaCl (150 g) was added to the reaction mixture, and stirring was continued for an additional 5 hours. The target substance was collected by filtration and washed with acetone.

The product, which is represented by the following formula, had a purity of 95% as determined by liquid chromatography, and an absorption peak of 388 nm.

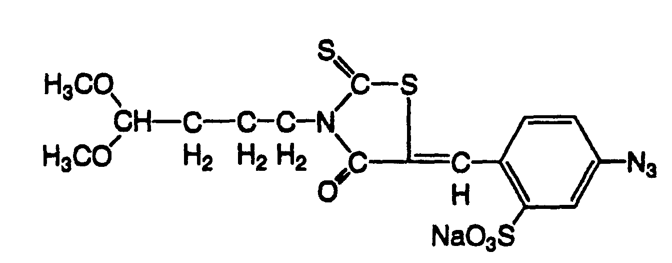

### (3) [Synthesis of Photosensitive Resin]

Polyvinyl alcohol (100 g)(GH-17, manufactured by Nippon Synthetic Chemical Industry Co., Ltd.) was dissolved in water (900 g). The compound (15 g) obtained in step (2) and phosphoric acid (3 g) were added to the mixture, followed by reaction at 60°C for 24 hours. The acetalization ratio was 90%. The reaction mixture was treated with an ion exchange resin to remove the phosphoric acid so as to prepare photosensitive liquid having a photosensitive group introduced in an amount of 1.3 mol% with respect to PVA. Thereafter, ion-exchanged water was added to the photosensitive liquid, to thereby adjust the solid content to 6%.

### (Photosensitive Resin Manufacture Example 3)

Polyvinyl alcohol (100 g)(EG-05, manufactured by Nippon Synthetic Chemical Industry Co., Ltd.) was dissolved in water (1800 g). The aforementioned compound obtained in step (2)(103 g) of the Photosensitive Resin Manufacture Example 2 and phosphoric acid (5 g) were added to the mixture, followed by reaction at 60°C for 24 hours. The reaction mixture was treated with an ion exchange resin to remove the phosphoric acid so as to prepare photosensitive liquid having a photosensitive group introduced in an amount of 10.0 mol% with respect to PVA. Thereafter, ion-exchanged water was added to the photosensitive liquid, to thereby adjust the solid content to 6%.

### (Test Example 1)

The photosensitive liquid of Photosensitive Resin Manufacture Example 1 was diluted to 5%. The liquid was applied to a glass plate to form a photosensitive film having a film thickness of 1.0 µm. The photosensitive film was exposed to light of an ultra-high pressure mercury lamp (ultraviolet illuminance: 5.0 mW/cm², UV-35 (an illuminance meter manufactured by ORC)) in an amount of 1 mJ. After the exposure, the photosensitive film was developed with water, confirming that a 50 µm-wide line was clearly resolved.

### (Test Example 2)

The photosensitive liquid of Photosensitive Resin Manufacture Example 2 was diluted to 5%. The liquid was coated on a glass plate to form a photosensitive film having a film thickness of 1.0 µm. The photosensitive film was exposed to light of an ultra-high pressure mercury lamp (ultraviolet illuminance: 5.0 mW/cm², UV-35 (an illuminance meter manufactured by ORC)) in an amount of 1 mJ. After the exposure, the photosensitive film was developed with water, confirming that a 50 µm-wide line was clearly resolved.

### (Example 1) Sensitivity Curve

Sensitivity curves of the following typical photosensitive liquids were obtained as described below.
Photosensitive Liquid A: Photosensitive liquid prepared in Manufacture Example 1 (solid content: 6%).
Photosensitive Liquid B: Photosensitive liquid prepared in Manufacture Example 1 (solid content: 6%): 80 g
6% aqueous polyvinylpyrrolidone solution: 18.2 g
6% aqueous DAS solution: 1.8 g

Each of Photosensitive Liquids A and B was coated on a glass plate having an area of 25 cm², and dried at 60°C for 5 minutes, to thereby obtain photosensitive films having a film thickness of 1 µm. The photosensitive films were exposed to light of an ultra-high pressure mercury lamp, at an intensity of illuminance of 0.15 mW/cm² (at 350 nm) for 2 to 50 seconds. After the exposure, the photosensitive films were developed with water and dried. The thickness of the cured films were measured, and remaining-film percentage was calculated. The results are shown in the table below and the graph.

**Table 1**

| Exposure time (sec) | Amount of exposure (mJ/cm²) | Residual film percentage of photosensitive liquid A | Residual film percentage of photosensitive liquid B |
|---|---|---|---|
| 2 | 0.3 | 0 | 17 |
| 5 | 0.75 | 0 | 54 |
| 8 | 1.20 | 31 | 72 |
| 10 | 1.50 | 46 | 75 |
| 12 | 1.80 | 54 | 75 |
| 15 | 2.25 | 61 | 80 |
| 20 | 3.00 | 69 | 88 |
| 50 | 7.50 | 82 | 91 |

A photosensitive film having a film thickness of 1 µm obtained from Photosensitive Liquid A was patternwise exposed to light of an ultra-high pressure mercury lamp (intensity of illuminance: 5.0 mW/cm² at 350 nm) through a chromium mask for 2 seconds and developed with water, to thereby form a fine pattern.

### (Example 2)

A 6% photosensitive liquid (20 g) obtained in the above described Manufacture Example 1, an aqueous polyvinylpyrrolidone solution (100 g, solid content: 6%), and 6% aqueous solution of sodium 4,4'-diazidostilbene-2, 2'-disulfonate (hereinafter referred to simply as "DAS") (10 g) were mixed together. The mixture was diluted to 3% and filtered through a membrane filter having a pore size of 1.0 µm.

The photosensitive liquid was spin coated on the inner face plate of a color cathode-ray tube, to thereby form a coating having a film thickness of 0.5 µm. The coating was dried at 50°C for 5 minutes, to thereby obtain a coating film.

Next, the coating film was exposed through a shadow mask to light of an ultra-high pressure mercury lamp at an intensity of illuminance of 0.10 mW/cm² (at 350nm) for 12 seconds.

After the exposure, the coating film was developed with water at 40°C for 30 seconds, to thereby obtain pattern dots endowed with excellent shape.

The photosensitive resin composition used as above showed reciprocity.

Next, carbon suspension was applied onto the dots. The dots and carbon thereon were removed by a remover, to thereby form a clear black matrix.

### (Example 3)

The procedure of Example 2 was repeated except that the photosensitive liquid obtained in Manufacture Example 2 was used instead of the photosensitive liquid obtained in Manufacture Example 1, to thereby form a black matrix.

### (Example 4)

A 6% photosensitive liquid (30 g) obtained in Manufacture Example 1 above, an aqueous polyvinylpyrrolidone solution (100 g, solid content: 6%), and a 6% aqueous DSA solution (10 g) were mixed together. Further, to the mixture was added KBM-603 (0.07 g)(a silane coupling agent manufactured by Shin-Etsu Chemical Co., Ltd.). The mixture was diluted to 3% and filtered through a membrane filter having a pore size of 1.0 µm, to thereby prepare a photosensitive liquid.

Through use of this photosensitive liquid, a clear black matrix was formed by the same method as used in Example 2.

### (Example 5)

A 6% photosensitive liquid (30 g) obtained in Manufacture Example 1 above and an aqueous polyvinylpyrrolidone solution (100 g, solid content: 6%) were mixed together. Further, to the mixture was added KBM-603 (0.05 g)(silane coupling agent manufactured by Shin-Etsu Chemical Co., Ltd.). The mixture was diluted to 3% and filtered through a membrane filter having a pore size of 1.0 µm, to thereby prepare a photosensitive liquid.

Through use of this photosensitive liquid, a clear black matrix was formed by the same method as used in Example 2.

### (Example 6)

A photosensitive composition having the following formulation was prepared.
10 wt.% Aqueous solution of the photosensitive resin prepared in Manufacture Example (1): 70 g
Red inorganic pigment (iron oxide, average particle size: 100 nm, manufactured by Ishihara Sangyo Kaisha, Ltd.): 28 g Pure water: 280 g
Silane coupling agent (KBM-603): 0.14 g, 5%
Tamol 731 (a surfactant manufactured by Rohm & Haas Co.): 1.5 g

The photosensitive composition formulated as above was spin-coated on a 10cm-by-10cm soda glass and dried, to thereby obtain a coating film having a film thickness of 1.0 µm. Subsequently, areas corresponding to red were exposed to light of an ultra-high pressure mercury lamp at an intensity of illuminance of 0.20 mW/cm² (at 350 nm on the surface of the glass plate) for 30 seconds under the following conditions: a shadow mask with a pitch 0.28 mm; distance between the shadow mask and the glass plate = 1 cm; and the distance between the shadow mask and the ultra-high pressure mercury lamp = 30 cm.

Subsequently, the coating film was developed with warm water sprayed by means of a sprayer (nozzle: No.3 manufactured by Spraying System, water pressure: 2.0 kg/cm², temperature: 40°C, distance: 15 cm).

The thus-obtained pattern was observed under a microscope, showing a faithful pattern of the red pigment film on the shadow mask.

### (Example 7)

The inner face plate of the color cathode-ray tube on which a black matrix was formed by the method used in Example 2 was coated with a 0.1% aqueous polyvinyl alcohol solution and dried. The plate was coated with phosphor slurry having the following formulation and dried, to thereby obtain a coating film having a film thickness of 10 to 12 µm. Next, through use of a 0.28-pitch shadow mask, the coating film was exposed for 25 seconds to light of an ultra-high pressure mercury lamp, at the intensity of illuminance of 0.12 mW/cm² (at 350 nm). After the exposure, the coating film was developed with water at 40°C for 30 seconds, to thereby form a pattern of phosphor fully charged with a green phosphor.

### (Composition of slurry containing a phosphor)

Green fluorescent substance: 100 g
Photosensitive liquid prepared in Manufacture Example 1 (solid content: 2.5%): 285 g
10% aqueous solution of LT-221 (a surfactant manufactured by NOF): 4.6 g
10% aqueous solution of L-62 (a surfactant manufactured by BASF): 1.8 g

### (Example 8)

The inner face plate of the color cathode-ray tube on which a black matrix had been formed by the method used in Example 2 was coated with a 0.1% aqueous polyvinyl alcohol solution and dried. The plate was coated with phosphor-containing slurry having the following formulation, dried, and there was formed a pattern of fluorescent by the same method used in Example 6 above.

### (Composition of slurry containing a phosphor)

Green phosphor: 100 g
Photosensitive liquid prepared in Manufacture Example 1 (solid content: 2.5%): 44 g
2.5% aqueous poly(N-vinylformamide) solution: 219 g
2.5% aqueous DAS solution: 22 g
10% aqueous solution of LT-221 (a surfactant manufactured by NOF): 4.6 g
10% aqueous solution of L-62 (a surfactant manufactured by BASF): 1.8 g

## Claims

1. A photosensitive compound or photosensitive resin, comprising a unit represented by the following formula: 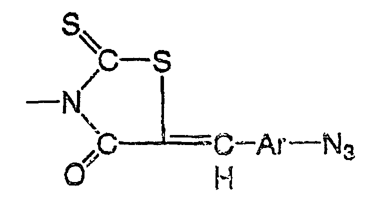 wherein Ar is selected from the following: 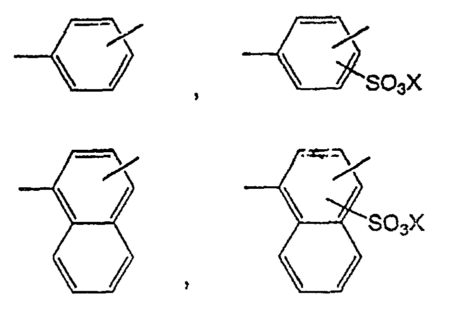 and X represents lithium, sodium, potassium, ammonium, monoalkylammonium, dialkylammonium, trialkylammonium, or tetraalkylammonium.

2. The compound of claim 1, which is represented by the following formula: 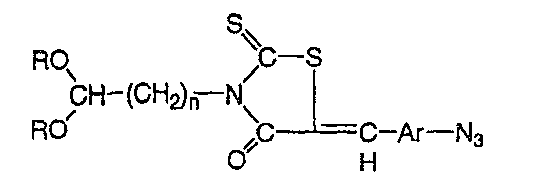 wherein R is selected from among C1-C6 alkyl groups and groups -(CH₂)ₘ- (m is 2 or 3) formed of two R's joined to each other; n is 1, 2, or 3; and Ar is defined as in claim 1.

3. The resin of claim 1 comprising a structural unit represented by the following formula: 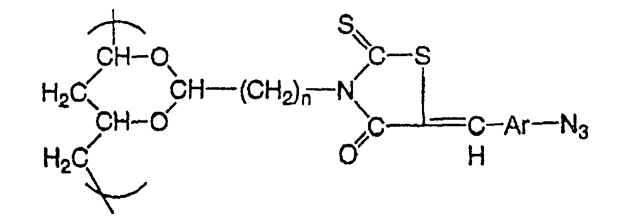 wherein n is 1, 2, or 3, and Ar is defined as in claim 1.

4. A photosensitive composition containing the photosensitive resin of claim 3.

5. A method for the manufacture of a photosensitive compound or photosensitive resin, containing an azide group, comprising the following reaction step: 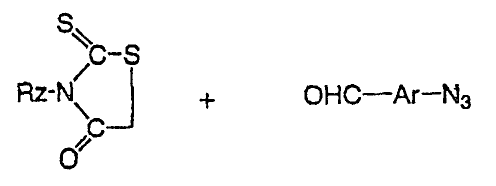 wherein Rz represents hydrogen or a substituent and Ar is selected from the following: 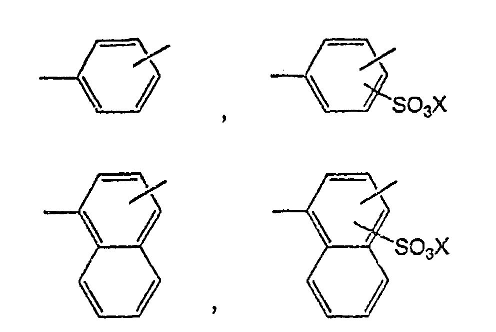 wherein X represents lithium, sodium, potassium, ammonium, monoalkylammonium, dialkylammonium, trialkylammonium, or tetraalkylammonium.

6. The method of claim 5, wherein Rz is a substituent having an acetal group.

7. The method of claim 6, further comprising the step of transforming the acetal group into a saponified product of polyvinyl acetate.

8. A pattern formation method comprising a coating film formation step in which a photosensitive resin composition containing a photosensitive resin having a structural unit represented by the following formula is applied onto a substrate to form a coating film of the photosensitive composition; an exposure step in which the coating film of the photosensitive composition is irradiated for a desired pattern; and a development step in which the patternwise exposed coating film is developed with water or an aqueous developer to form a photo-cured pattern: 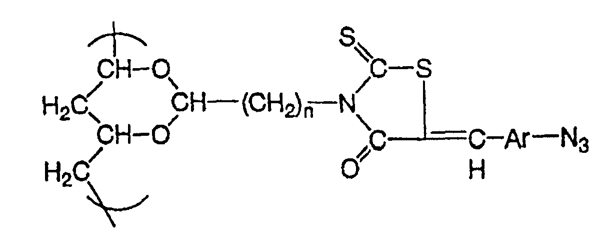 wherein n is 1, 2, or 3, and Ar is selected from the following: 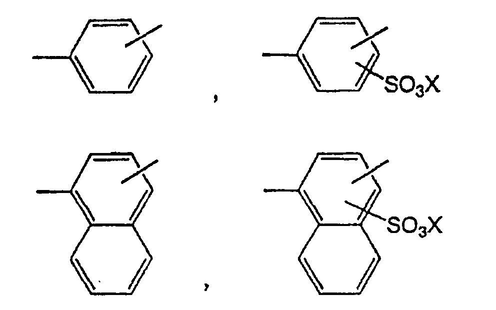 wherein X represents lithium, sodium, potassium, ammonium, monoalkylammonium, dialkylammonium, trialkylammonium, or tetraalkylammonium.

9. The method of claim 8, wherein the photosensitive resin composition further contains a water-soluble polymer or a water-soluble azide compound.

10. The method of claim 8, wherein the substrate is an inner face plate of a colour cathode-ray tube.

11. The method of claim 10, further comprising, after the development step, a step of applying a graphite slurry onto the entirety of the photo-cured pattern and drying to form a graphite coating film, and a step of removing the photo-cured pattern by use of a remover to form a black matrix.

12. The method of claim 10, wherein the photosensitive resin composition further contains a phosphor, and a phosphor pattern may be formed through the development step.

13. The method of claim 10, wherein the photosensitive resin composition further contains a pigment, and a colour filter is formed through the development step.

## Patentansprüche

1. Lichtempfindliche Verbindung oder lichtempfindliches Harz mit einer Gruppe gemäß folgender Formel: 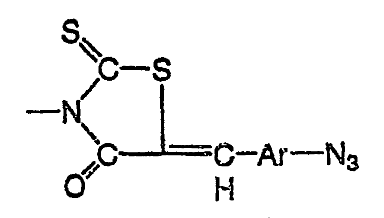 wobei Ar einem der folgenden Bausteine entspricht: 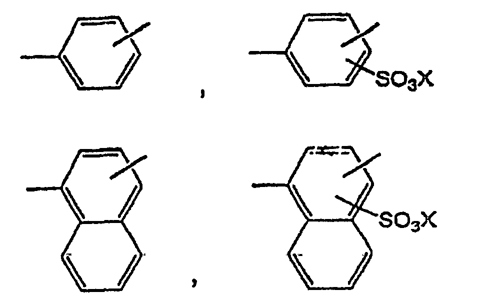 und X Lithium, Natrium, Kalium, Ammonium, Monoalkylammonium, Dialkylammonium, Trialkylammonium oder Tetraalkylammonium entspricht.

2. Verbindung nach Anspruch 1, gemäß folgender Formel: 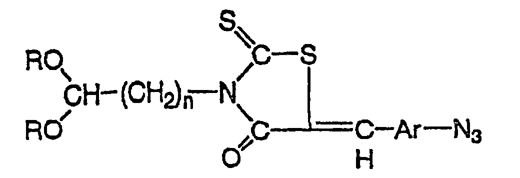 wobei R einer C1- bis C6-Alkylgruppe oder -(CH₂)ₘ-(m = 2 oder 3) entspricht, die durch zwei miteinander verbundene Rs gebildet werden; n = 1, 2 oder 3; und Ar gemäß Anspruch 1 definiert ist.

3. Harz nach Anspruch 1 mit einer strukturellen Gruppe, die der folgenden Formel entspricht: 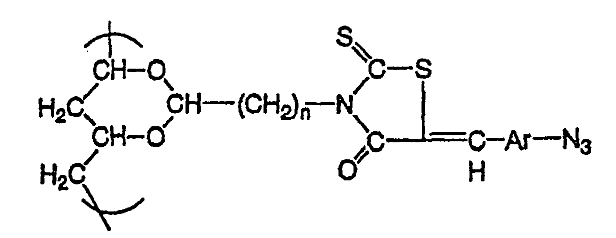 wobei n = 1, 2 oder 3 und Ar gemäß Anspruch 1 definiert ist.

4. Lichtempfindliche.Zusammensetzung, die das lichtempfindliche Harz nach Anspruch 3 enthält.

5. Verfahren zur Herstellung einer lichtempfindlichen Verbindung oder eines lichtempfindlichen Harzes, jeweils eine Azidgruppe enthaltend, mit folgendem Reaktionsschritt: 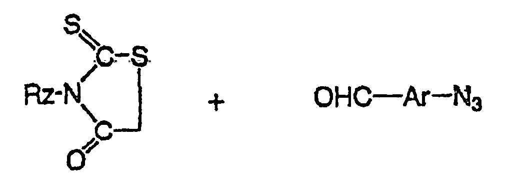 wobei Rz Wasserstoff oder einem Substituenten entspricht und Ar einer der folgenden Gruppen entspricht: 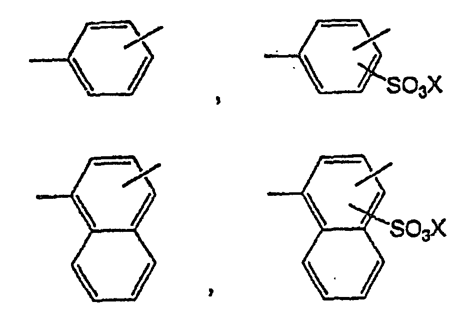 wobei X Lithium, Natrium, Kalium, Ammonium,, Monoalkylammonium, Dialkylammonium, Trialkylammonium oder Tetraalkylammonium entspricht.

6. Verfahren nach Anspruch 5, wobei Rz ein Substituent mit einer Acetalgruppe ist.

7. Verfahren nach Anspruch 6, mit dem weiteren Schritt: Umformen der Acetalgruppe in ein verseiftes Polyvinylacetat-Produkt.

8. Verfahren zur Herstellung eines Musters mit den Schritten: Bilden eines Beschichtungsfilms, in dem eine lichtempfindliche Harzzusammensetzung, die ein lichtempfindliches Harz mit einer Strukturgruppe entsprechend der folgenden Formel enthält, auf ein Substrat aufgebracht wird, um einen Beschichtungsfilm aus der lichtempfindlichen Zusammensetzung zu bilden, Belichten des Beschichtungsfilms aus der lichtempfindlichen Zusammensetzung mit einem gewünschten Muster, Entwickeln des entsprechend dem Muster belichteten Beschichtungsfilms mit Wasser oder einem wäßrigen Entwickler, um ein lichtfixiertes Muster zu erhalten: 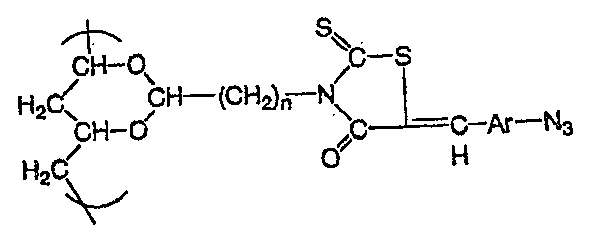 wobei n = 1, 2 oder 3, und Ar einer der folgenden Gruppen entspricht: 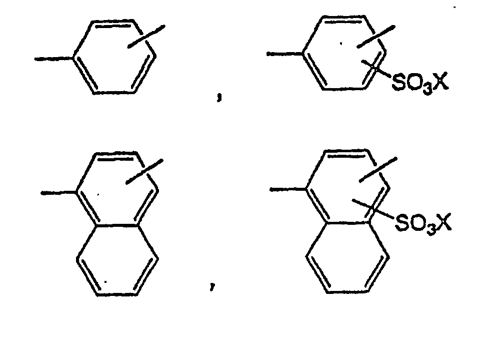 wobei X Lithium, Natrium, Kalium, Ammonium, Monoalkylammonium, Dialkylammonium, Trialkylammonium oder Tetraalkylammonium entspricht.

9. Verfahren nach Anspruch 8, wobei die lichtempfindliche Harzzusammensetzung zusätzlich ein wasserlösliches Polymer oder eine wasserlösliche Azidzusammensetzung enthält.

10. Verfahren nach Anspruch 8, wobei das Substrat eine innere Stirnfläche einer Farb-Kathodenstrahlröhre ist.

11. Verfahren nach Anspruch 10, wobei nach dem Entwicklungsschritt folgende zusätzliche Schritte ausgeführt werden: Aufbringen eines Graphitschlamms auf das gesamte photofixierte Muster und Trocknen des Schlamms, um einen Graphitbeschichtungsfilm zu bilden, und Entfernen des photofixierten Musters unter Verwendung eines Entferners, um eine schwarze Matrix zu bilden.

12. Verfahren nach Anspruch 10, wobei die lichtempfindliche Harzzusammensetzung zusätzlich Phosphor enthält und beim Entwickeln ein Phosphormuster gebildet werden kann.

13. Verfahren nach Anspruch 10, wobei die lichtempfindliche Harzzusammensetzung zusätzlich ein Pigment enthält, und beim Entwickeln ein Farbfilter gebildet wird.

## Revendications

1. Composé photosensible ou résine photosensible comprenant un motif représenté par la formule suivante : 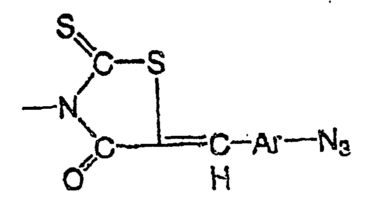 dans laquelle Ar est choisi parmi les groupes suivants 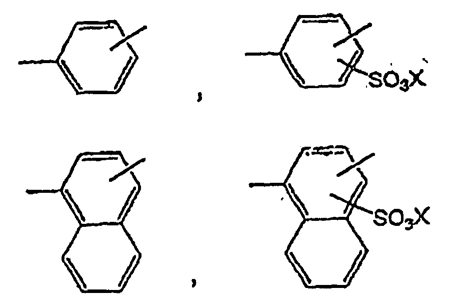 et X représente un atome de lithium, de sodium, de potassium, un groupe ammonium, monoalkylammonium, dialkylammonium, trialkylammonium ou tétraalkylammonium.

2. Composé selon la revendication 1, qui est représenté par la formule suivante : 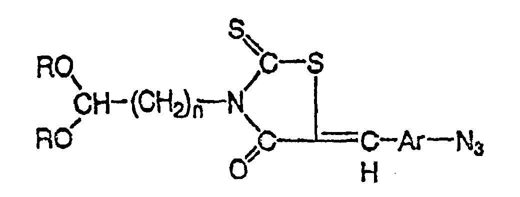 dans laquelle R est choisi parmi les groupes alkyle en C₁-C₆ et les groupes -(CH₂)ₘ- (m est égal à 2 ou à 3) formés de deux symboles R liés l'un à l'autre ; n est égal à 1, 2 ou 3 ; et Ar est tel que défini dans la revendication 1.

3. Résine selon la revendication 1, comprenant un motif constitutif qui est représenté par la formule suivante : 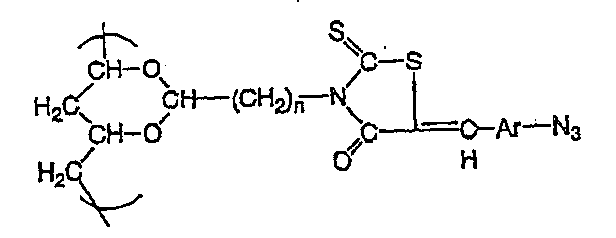 dans laquelle n est égal à 1, 2 ou 3 ; et Ar est tel que défini dans la revendication 1.

4. Composition photosensible contenant la résine photosensible selon la revendication 3.

5. Procédé de fabrication d'un composé photosensible ou d'une résine photosensible contenant un groupe azide, comprenant l'étape de réaction suivante : 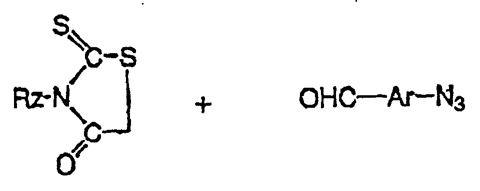 dans laquelle Rz représente un atome d'hydrogène ou un substituant et Ar est choisi parmi les groupes suivants 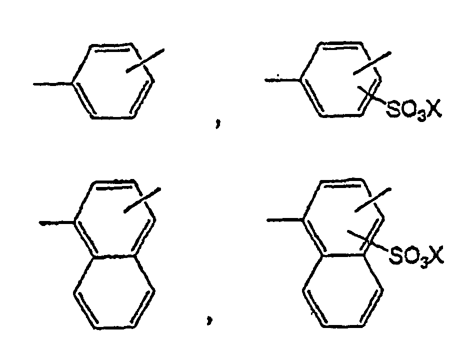 où X représente un atome de lithium, de sodium, de potassium, un groupe ammonium, monoalkylammonium, dialkylammonium, trialkylammonium ou tétraalkylammonium.

6. Procédé selon la revendication 5, dans lequel Rz représente un substituant ayant un groupe acétal.

7. Procédé selon la revendication 6, comprenant en outre l'étape consistant à transformer le groupe acétal en un produit saponifié de poly(acétate de vinyle).

8. Procédé de formation de motif comprenant une étape de formation d'un film de revêtement dans laquelle on appliqué une composition de résine photosensible contenant une résine photosensible ayant un motif constitutif représenté par la formule suivante sur un substrat pour former un film de revêtement de la composition photosensible ; une étape d'exposition dans laquelle on expose à un rayonnement le film de revêtement de la composition photosensible de manière à former un motif voulu ; et une étape de développement dans laquelle on développe le film de revêtement exposé de manière à former un motif avec de l'eau ou un révélateur aqueux pour former un motif photodurci : 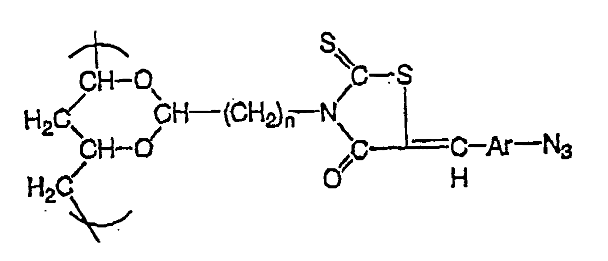 où n est égal à 1, 2 ou 3 ; et Ar est choisi parmi les groupes suivants 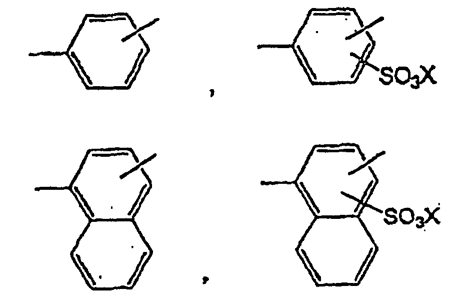 où X représente un atome de lithium, de sodium, de potassium, un groupe ammonium, monoalkylammonium, dialkylammonium, trialkylammonium ou tétraalkylammonium.

9. Procédé selon la revendication 8, dans lequel la composition de résine photosensible contient en outre un polymère soluble dans l'eau ou un composé de type azide soluble dans l'eau.

10. Procédé selon la revendication 8, dans lequel le substrat est la plaque frontale intérieure d'un tube à rayons cathodique couleur.

11. Procédé selon la revendication 10 comprenant en outre, après l'étape de développement, une étape d'application d'une suspension de graphite sur l'intégralité du motif photodurci et de séchage pour former un film de revêtement de graphite, et une étape d'enlèvement du motif photodurci en utilisant un décapant pour former une matrice noire.

12. Procédé selon la revendication 10, dans lequel la composition de résine photosensible contient en outre une substance phosphorescente, et on peut former un motif phosphorescent par l'étape de développement.

13. Procédé selon la revendication 10, dans lequel la composition de résine photosensible contient en outre un pigment, et on forme un filtre coloré par l'étape de développement.
